# EUROPÄISCHE PATENTSCHRIFT

(11) **EP 2 807 363 B1**
(45) Veröffentlichungstag und Bekanntmachung des Hinweises auf die Patenterteilung: **10.01.2018**
(21) Anmeldenummer: 13700685.4
(22) Anmeldetag: 14.01.2013
(51) Int. Cl.: F02D 41/20, H01L 41/04

(54) **VERFAHREN UND ANSTEUEREINRICHTUNG ZUM AUFLADEN ODER ENTLADEN EINES PIEZOELEKTRISCHEN AKTORS**
METHOD AND CONTROL DEVICE FOR CHARGING OR DISCHARGING A PIEZO-ELECTRIC ACTUATOR
PROCÉDÉ ET DISPOSITIF DE COMMANDE POUR CHARGER OU DÉCHARGER UN ACTIONNEUR PIÉZOÉLECTRIQUE

(30) Priorität: 26.01.2012 DE 102012201161
(43) Veröffentlichungstag der Anmeldung: 03.12.2014
(73) Patentinhaber: Robert Bosch GmbH, 70442 Stuttgart (DE)
(72) Erfinder: BARTH, Jens-Holger, 70736 Fellbach (DE); KRIEG, Markus, 71272 Renningen (DE); OSTENDORF, Boris, 70193 Stuttgart (DE); GRAF, Marco, 71254 Ditzingen (DE)
(86) Internationale Anmeldenummer: PCT/EP2013/050564
(87) Internationale Veröffentlichungsnummer: WO 2013/110522

(56) Entgegenhaltungen:
- EP-A1- 2 290 211
- EP-A2- 2 022 970
- DE-A1- 19 733 560
- DE-A1-102009 000 986

## Beschreibung

### Stand der Technik

Die Erfindung betrifft ein Verfahren zum Aufladen oder Entladen eines piezoelektrischen Aktors, insbesondere eines Einspritzventils einer Brennkraftmaschine, wobei ein erster Anschluss des Aktors zumindest zeitweise über eine Transferinduktivität an ein erstes Bezugspotential gelegt wird.

Die Erfindung betrifft ferner eine Ansteuereinrichtung zur Ausführung eines derartigen Verfahrens.

Aus der EP 1 139 448 B1 ist bereits ein Verfahren und eine Ansteuereinrichtung zum Aufladen oder Entladen eines piezoelektrischen Aktors bekannt. Das bekannte Verfahren ermöglicht jedoch insbesondere bei verhältnismäßig kurzzeitigen Ansteuerungen des piezoelektrischen Aktors nur eine eingeschränkte Genauigkeit bezüglich des Aufladens bzw. Entladens des piezoelektrischen Aktors. Insbesondere wird sich während des Betriebs der Ansteuereinrichtung bzw. des Aktors ändernden Größen nur unzureichend Rechnung getragen. Ebenso ist aus der DE 197 33 560 A1 ein Verfahren und eine Vorrichtung zum Aufladen oder Entladen eines piezoelektrischen Aktors bekannt, welche auf der Spannung über den Aktor und dem Strom durch den Aktor basiert.

### Offenbarung der Erfindung

Demgemäß ist es Aufgabe der vorliegenden Erfindung, ein Verfahren und eine Ansteuereinrichtung der eingangs genannten Art dahingehend zu verbessern, dass eine präzisere Aufladung bzw. Entladung des piezoelektrischen Aktors ermöglicht wird, wodurch insbesondere auch Kraftstoffeinspritzungen mit besonders geringen Kraftstoffmengen durchgeführt werden können.

Diese Aufgabe wird bei dem Verfahren der eingangs genannten Art erfindungsgemäß dadurch gelöst, dass eine Ansteuerung des Aktors in Abhängigkeit einer Potentialdifferenz zwischen dem ersten Bezugspotential und einem Potential an dem ersten Anschluss des Aktors ausgeführt wird.

Erfindungsgemäß ist erkannt worden, dass die Potentialdifferenz zwischen dem ersten Bezugspotential und dem Potential an dem ersten Anschluss des Aktors einen wesentlichen Einfluss auf den zeitlichen Verlauf eines für das Aufladen bzw. Entladen des piezoelektrischen Aktors verwendeten Stroms hat. Die erfindungsgemäße Berücksichtigung dieser Potentialdifferenz ermöglicht daher eine besonders genaue Ansteuerung des piezoelektrischen Aktors, sodass insbesondere auch verhältnismäßig kurze Ansteuerzeiten mit gegenüber dem Stand der Technik gesteigerter Präzision erreichbar sind. Für eine besonders präzise Ansteuerung des Aktors ist vorgesehen, dass die Potentialdifferenz wiederholt ermittelt wird. Bspw. kann die Potentialdifferenz bei bzw. vor jeder (geplanten) Betriebszustandsänderung des piezoelektrischen Aktors oder eines den Aktor enthaltenden Einspritzsystems ermittelt werden. Besonders vorteilhaft kann auch eine periodische Ermittlung der Potentialdifferenz vorgesehen sein, wodurch sichergestellt ist, dass die Ansteuerung des Aktors stets in Abhängigkeit der tatsächlich vorliegenden Potentialdifferenz ausgeführt werden kann. Insbesondere ist es zweckmäßig, wenn die Potentialdifferenz vor einer geplanten Ansteuerung des Aktors ermittelt wird, besonders bevorzugt möglichst kurzfristig davor, um unnötige Fehler durch eine zwischenzeitliche Änderung der Potentialdifferenz zwischen dem Zeitpunkt der Ermittlung der Potentialdifferenz und der Ansteuerung des Aktors möglichst gering zu halten.

Bei einer weiteren vorteilhaften Ausführungsform ist vorgesehen, dass der Aktor unter Verwendung von Strompulsen aufgeladen und/oder entladen wird, wodurch das erfindungsgemäße Verfahren kompatibel ist zu bestehenden Architekturen von Ansteuereinrichtungen für piezoelektrische Aktoren. Durch die Verwendung von Strompulsen ist ferner eine sehr genaue Einstellung eines mittleren Ladestroms bzw. Entladestroms für den piezoelektrischen Aktor möglich.

Bei einer weiteren vorteilhaften Ausführungsform ist vorgesehen, dass für das Aufladen der erste Anschluss des Aktors mindestens einmal, vorzugsweise jedoch mehrmals, solange an das erste Bezugspotential gelegt wird, bis ein über die Transferinduktivität in den Aktor fließender Aufladestrom einen vorgebbaren ersten Sollwert überschreitet. Sobald das Überschreiten des ersten Sollwerts erkannt worden ist kann der Aktor bzw. die Transferinduktivität vorteilhaft wieder von dem ersten Bezugspotential getrennt werden, wobei ein bei dem Abbau des Magnetfelds der Transferinduktivität weiter durch die Transferinduktivität fließender Strom weiter in den Aktor fließt. Besonders bevorzugt kann ferner nach dem Unterschreiten eines Stromsollwerts für den Aufladestrom erneut der erste Anschluss des Aktors an das erste Bezugspotential gelegt werden (über die Transferinduktivität), um den Ladestrom in an sich bekannter Weise wieder zu erhöhen.

Durch die vorstehend beschriebene Verfahrensweise lässt sich ein Aufladen des piezoelektrischen Aktors unter Verwendung von Strompulsen besonders effizient realisieren. Durch die erfindungsgemäße Berücksichtigung der Potentialdifferenz für die Ansteuerung des Aktors kann dabei vorteilhaft mit besonders großer Präzision auch ein verhältnismäßig geringer mittlerer Ladestrom für den piezoelektrischen Aktor eingestellt werden, auch dann, wenn die Potentialdifferenz zwischen dem piezoelektrischen Aktor, bzw. seinem ersten Anschluss und dem für die Aufladung verwendeten Bezugspotential verhältnismäßig groß ist. Dadurch kann generell die Genauigkeit des Aktorladens und damit auch des mit dem Aufladen einhergehenden Aktorhubs verbessert werden, was insbesondere bei der Verwendung des Aktors zur Betätigung von Elementen eines Einspritzventils vorteilhaft ist.

Insgesamt kann durch die Anwendung des erfindungsgemäßen Verfahrens ein zeitlicher Verlauf des Aufladestroms bzw. Entladestroms durch den Aktor genauer gestellt werden. Besonders vorteilhaft entsteht hierbei auch weniger Verlustleistung, weil eine geringere mittlere Schaltspannung an Lade- bzw. Entladeschaltern anliegt, wie sie bspw. durch Halbleiterschalter realisiert sind, die die Transferinduktivität mit dem betreffenden Bezugspotential verbinden bzw. diese hiervon trennen.

Ein weiterer Vorteil der Erfindung besteht darin, dass bei der Verwendung des piezoelektrischen Aktors die Darstellbarkeit von kleinen und kleinsten Einspritzmengen verbessert wird bei gleichzeitiger Verringerung von Hub-Zu-Hub-Streuungen.

Bei einer weiteren vorteilhaften Ausführungsform ist vorgesehen, dass für das Entladen der erste Anschluss des Aktors mindestens einmal, vorzugsweise jedoch mehrmals, solange an ein zweites Bezugspotential gelegt wird, bis ein über die Transferinduktivität aus dem Aktor fließender Entladestrom einen vorgebbaren zweiten Sollwert überschreitet. Für das zweite Bezugspotential wird bspw. ein gemeinsames Massepotential einer den Aktor ansteuernden Ansteuereinrichtung verwendet, während für das erste Bezugspotential bspw. ein hiervon verschiedenes, insbesondere größeres, Potential wie bspw. eine Kfz-Bordnetzspannung oder eine aus dieser Kfz-Bordnetzspannung abgeleitete höhere Gleichspannung, verwendet wird.

Bei einer weiteren vorteilhaften Ausführungsform ist vorgesehen, dass ein kapazitives Element verwendet wird, um das erste Bezugspotential bereit zu stellen, und dass eine Spannung, die an dem kapazitiven Element anliegt, ermittelt wird, wobei vorzugsweise auch eine an dem Aktor anliegende Spannung ermittelt wird. Bei dem kapazitiven Element kann es sich beispielsweise um einen Pufferkondensator handeln, der über eine geeignete Ladeschaltung auf die gewünschte Spannung aufgeladen wird. Bei der Nennspannung des Pufferkondensators kann es sich bspw. um eine elektrische Spannung handeln, die geringfügig größer ist als die maximale Spannung, auf die der Aktor während seines Betriebs aufzuladen ist.

Die erfindungsgemäße Berücksichtigung der Potentialdifferenz zwischen dem ersten Bezugspotential und dem Potential an dem ersten Anschluss des Aktors kann bei der vorliegenden Ausführungsform bspw. dadurch erfolgen, dass die Spannung an dem Pufferkondensator ermittelt wird, und dass die Spannung an dem Aktor ermittelt wird. Aus diesen Informationen kann auch die Potentialdifferenz zwischen dem ersten Bezugspotential und dem Potential an dem ersten Anschluss des Aktors geschlossen werden, was insbesondere dann besonders einfach ist, wenn sowohl der Aktor als auch der Pufferkondensator als gemeinsames Bezugspotential ein Massepotential haben. In diesem Fall entspricht eine Potentialdifferenz zwischen dem ersten Bezugspotential und dem gemeinsamen Massepotential der Spannung an den Pufferkondensator, und eine Potentialdifferenz zwischen dem ersten Anschluss des piezoelektrischen Aktors und dem gemeinsamen Massenpotential entspricht der an dem piezoelektrischen Aktor anliegenden Spannung.

Bei der Vorsehung von Längswiderständen, die in Serie zu dem piezoelektrischen Aktor geschaltet sind und bspw. einen besonders geringen Widerstandswert aufweisen, wodurch eine Strommessung in an sich bekannter Weise ermöglicht wird, ist das Erfindungsprinzip ebenso vorteilhaft anwendbar, wobei ggf. ein an den Längswiderständen auftretender Spannungsabfall berücksichtigt werden kann.

Bei einer weiteren vorteilhaften Ausführungsform ist vorgesehen, dass mindestens eine einen zeitlichen Verlauf des während des Aufladens durch den Aktor fließenden Stroms beeinflussende Größe in Abhängigkeit der Potentialdifferenz zwischen dem ersten Bezugspotential bzw. dem zweiten Bezugspotential und dem Potential an dem ersten Anschluss des Aktors gewählt wird. Bei der den Aufladestrom beeinflussenden Größe kann es sich bspw. um Parameter eines Strompulsmusters, das für die Aufladung verwendet werden soll, handeln. Insbesondere kann es sich um die vorstehend bereits beschriebenen ersten bzw. zweiten Sollwerte für den Ladestrom bzw. den Entladestrom handeln. Das Funktionsprinzip der vorliegenden Ausführungsform kann analog auch auf einen Entladevorgang des Aktors angewandt werden.

Während des Aufladens wird vorteilhaft eine Potentialdifferenz zwischen dem ersten Bezugspotential und dem Potential des ersten Anschlusses des piezoelektrischen Aktors betrachtet, wohingegen bei dem Entladen eine Potentialdifferenz zwischen dem zweiten Bezugspotential (z. B. Masse) und dem Potential des ersten Anschlusses des piezoelektrischen Aktors betrachtet wird, um die vorstehend beschriebene beeinflussende Größe zu wählen.

Bei einer weiteren vorteilhaften Ausführungsform ist vorgesehen, dass der erste Sollwert und/oder der zweite Sollwert (für den Lade- bzw. Entladestrom) in Abhängigkeit der Potentialdifferenz gewählt werden. Besonders bevorzugt kann zusätzlich der erste und/oder der zweite Sollwert in Abhängigkeit von mindestens einer Latenzzeit einer den Aktor ansteuernden Ansteuereinrichtung oder von Komponenten hiervon gewählt werden. Hierdurch kann zeitlichen Änderungen der betrachteten Betriebsgrößen (Strom, Spannung) Rechnung getragen werden, die sich dadurch ergeben, dass die Ansteuereinrichtung Betriebszustandsänderungen bzw. Änderungen von Steuergrößen nicht beliebig schnell ausführen bzw. umsetzen kann, sondern nur unter Vorliegen der betrachteten Latenzzeiten (z.B. Signallaufzeiten bei der Ansteuerung von Halbleiterschaltern bzw. von Treiberstufen hierfür oder von einer Recheneinheit usw.). Besonders vorteilhaft kann zusätzlich die Induktivität der Transferinduktivität, also der tatsächliche Induktivitätswert der Transferinduktivität, berücksichtigt werden, um den ersten Sollwert für den Ladestrom bzw. den zweiten Sollwert für den Entladestrom zu wählen. Als eine weitere Lösung der Aufgabe der vorliegenden Erfindung ist eine Ansteuereinrichtung gemäß Patentanspruch 8 vorgesehen. Weitere vorteilhafte Ausgestaltungsformen sind Gegenstand der Unteransprüche.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung beziehungsweise Darstellung in der Beschreibung beziehungsweise in der Zeichnung.

In der Zeichnung zeigt:
- Figur 1: Schematisch eine Schaltungsanordnung einer ersten Ausführungsform einer erfindungsgemäßen Ansteuereinrichtung,
- Figur 2a: die Schaltungsanordnung gemäß Figur 1 in einem für das Aufladen des piezoelektrischen Aktors verwendeten ersten Betriebszustand,
- Figur 2b: Die Schaltungsanordnung gemäß Figur 1 in einem für das Entladen des piezoelektrischen Aktors verwendeten zweiten Betriebszustand,
- Figur 3: schematisch ein Zeitdiagramm verschiedener Betriebsgrößen des piezoelektrischen Aktors während eines Aufladevorgangs,
- Figur 4: schematisch ein Blockdiagramm gemäß einer weiteren Ausführungsform der Erfindung, und
- Figur 5: ein vereinfachtes Flussdiagramm einer Ausführungsform des erfindungsgemäßen Verfahrens.

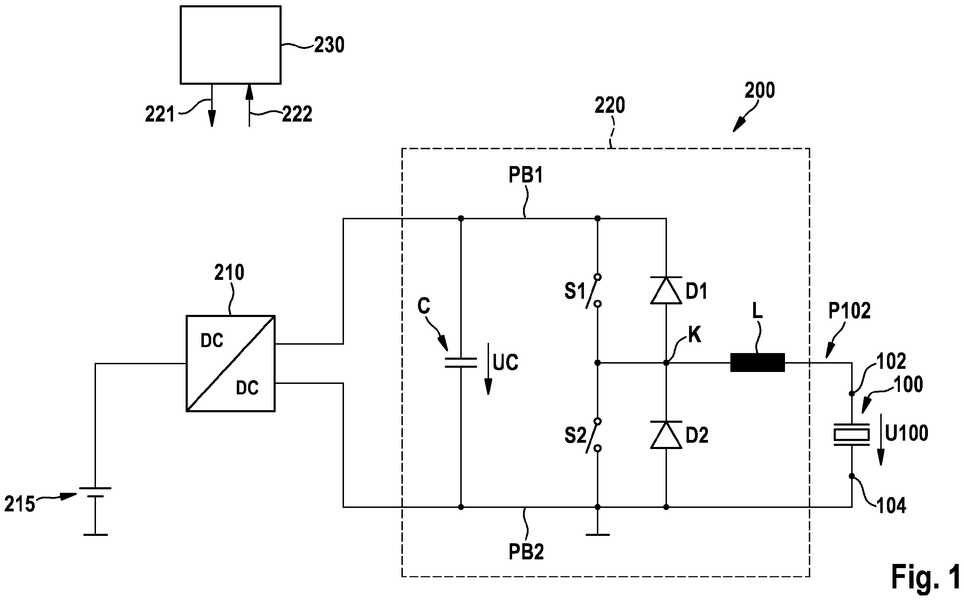

Figur 1 zeigt eine Schaltungsanordnung 220 einer Ansteuereinrichtung 200 für einen piezoelektrischen Aktor 100. Die Ansteuereinrichtung 200 weist einen DC (direct current)/DC-Wandler 210 auf, der aus einer ihm eingangsseitig durch eine Spannungsquelle 215 (z. B. Kfz-Boardnetzbatterie) zugeführten Gleichspannung eine Ausgangsgleichspannung erzeugt, die bspw. größer ist als die Eingangsspannung der Spannungsquelle 215. Vorliegend kann die Ausgangsspannung des DC/DC-Wandlers 210 bspw. etwa 200 Volt betragen.

Ein Pufferkondensator C der Schaltungsanordnung 220 der Ansteuereinrichtung 200 wird durch den DC/DC-Wandler 210 auf die Ausgangsspannung des DC/DC-Wandlers 210 aufgeladen. Die an dem Pufferkondensator C anliegende Spannung ist vorliegend mit dem Bezugszeichen UC bezeichnet. Da ein in Fig. 1 unterer Anschluss des Pufferkondensators C direkt mit einem gemeinsamen Massepotential, das einem zweiten Bezugspotential PB2 entspricht, verbunden ist, entspricht die Spannung UC an dem Pufferkondensator C einer Potentialdifferenz aus einem ersten Bezugspotential PB 1, das an dem in Figur 1 oberen Anschluss des Pufferkondensators C anliegt, und dem gemeinsamen Massepotential PB2.

Die Schaltungsanordnung 220 weist ferner einen ersten Schalter S1 und einen zweiten Schalter S2 auf, die zueinander in Serie geschaltet sind. Die Serienschaltung der Schalter S1 und S2 ist wie aus Figur 1 ersichtlich parallel geschaltet zu dem Pufferkondensator C.

Ebenfalls parallel geschaltet zu dem Pufferkondensator C ist eine Serienschaltung aus zwei Dioden D1, D2, wobei die Kathode der ersten Diode D1 mit dem in Figur 1 oberen Anschluss des Pufferkondensators C, also mit dem ersten Bezugspotential PB1, verbunden ist, während die zweite Diode D2 so angeordnet ist, dass ihre Anode mit dem Massepotential bzw. dem zweiten Bezugspotential PB2 verbunden ist.

Zwischen den Dioden D1 und D2 und den Schaltern S1, S2 ist ein Knotenpunkt K definiert, an den eine Transferinduktivität L mit einem nicht näher in Figur 1 bezeichneten ersten Anschluss angeschlossen ist. Ein zweiter Anschluss der Transferinduktivität L ist an den ersten Anschluss 102 des piezoelektrischen Aktors 100 geschaltet. Ein zweiter Anschluss 104 des piezoelektrischen Aktors 100 ist vorliegend mit dem gemeinsamen zweiten Bezugspotential PB2 (Massepotential) verbunden.

Die Steuerung der Ansteuereinrichtung 200, insbesondere der Schalter S1, S2, bei denen es sich bspw. um Halbleiterschalter (z.B. für Schaltanwendungen optimierte Feldeffekttransistoren) handeln kann, erfolgt vorliegend über die Steuereinrichtung 230. Hierzu gibt die Steuereinrichtung 230 entsprechende Ausgangssignale 221, z.B. an die Schalter S1, S2, ab. Ferner empfängt die Steuereinrichtung 230 auch ein oder mehrere Eingangssignale 222, bei denen es sich um digitale oder auch analoge Größen handeln kann, bspw. das Potential PB1 bzw. die Spannung UC an den Pufferkondensator C und/oder das Potential P102 an dem ersten Anschluss 102 des Aktors 100 usw. charakterisierende Größen.

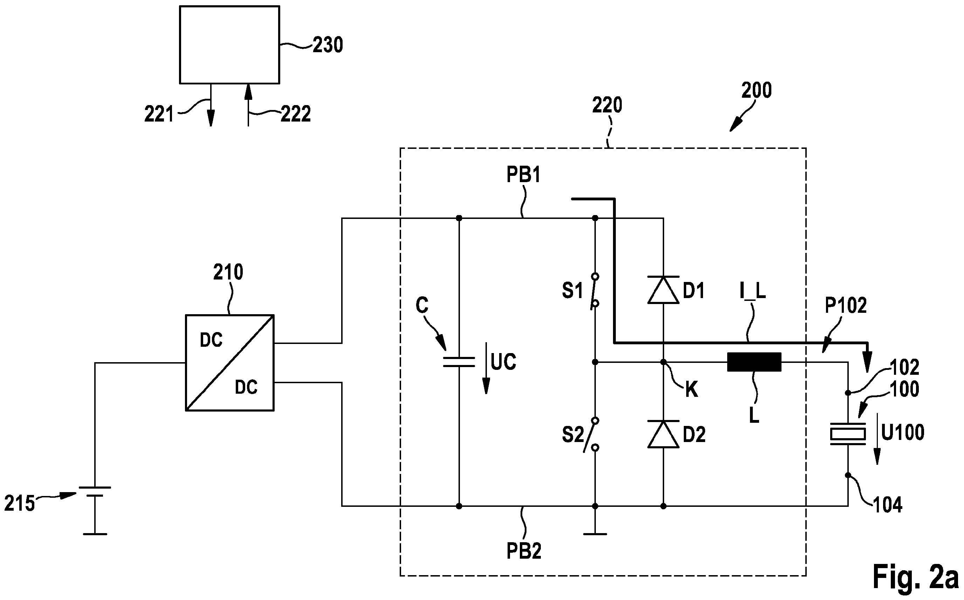

Zum Aufladen des piezoelektrischen Aktors 100 steuert die Steuereinrichtung 230 die Schalter S1, S2 in den in Figur 2a gezeigten Zustand. Das bedeutet, der erste Schalter S1 ist geschlossen, und der zweite Schalter S2 ist geöffnet. Dadurch wird ein Strompfad zwischen dem ersten Bezugspotential PB1 über den ersten Schalter S1, über die Transferinduktivität L und den ersten Anschluss 102 des piezoelektrischen Aktors 100 und schließlich zu dem gemeinsamen Bezugspotential PB2 (Masse) definiert, der einen Stromfluss I_L aus dem Pufferkondensator C durch die Transferinduktivität L hindurch in den piezoelektrischen Aktor 100 ermöglicht. Dieser Stromfluss repräsentiert den Lade- bzw. Aufladestrom I_L, mit dem der piezoelektrische Aktor 100 elektrisch aufgeladen wird. Sobald der Aktor 100 nicht weiter aufgeladen werden soll, kann die Steuereinrichtung 230 bspw. den ersten Schalter S1 öffnen, wodurch sich zunächst ein Stromfluss durch die Transferinduktivität L weiter fortsetzt, nämlich durch die Elemente D2, L, 100. Nach dem Abbau des Magnetfelds der Transferinduktivität L findet jedoch kein weiterer Ladevorgang des piezoelektrischen Aktors 100 statt, sofern die Schalter S1, S2 geöffnet bleiben.

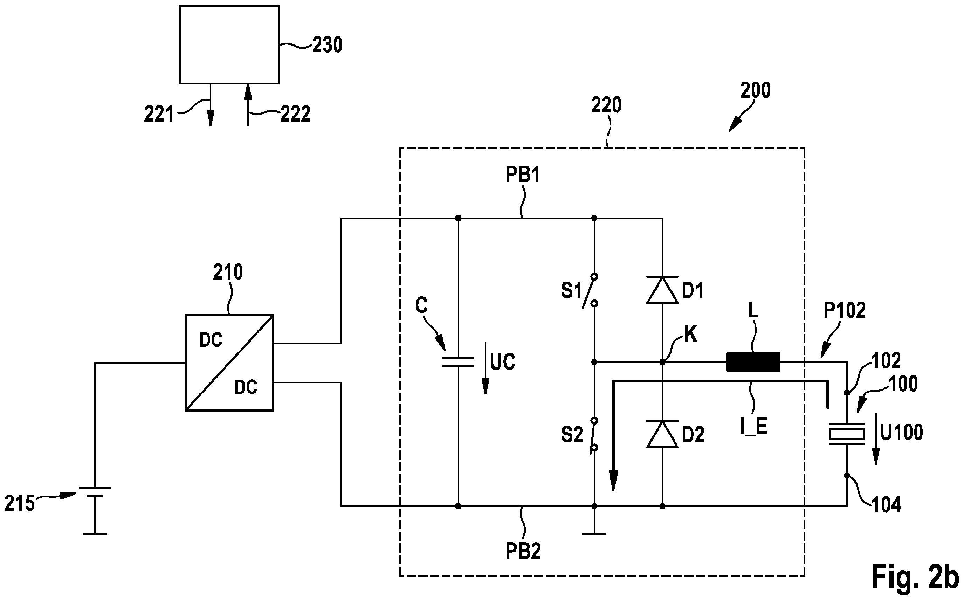

Figur 2b zeigt die Ansteuereinrichtung 200 in einem zweiten Betriebszustand, der vorliegend für das Entladen des piezoelektrischen Aktors 100 verwendet wird. Bei dem zweiten Betriebszustand ist der erste Schalter S1 geöffnet und der zweite Schalter S2 geschlossen. Auf diese Weise wird ein Strompfad gebildet zwischen dem ersten Anschluss 102 des Aktors 100, über die Transferinduktivität L und den geschlossenen zweiten Schalter S2 hin zu dem Massepotential PB2. Hierdurch kann ein Entladestrom I_E aus dem Aktor 100 über die Transferinduktivität L zu dem Massepotential PB2 fließen, der den piezoelektrischen Aktor 100 in an sich bekannter Weise entlädt. Sobald der piezoelektrische Aktor 100 nicht mehr weiter entladen werden soll, öffnet der zweite Schalter S2, und für den Abbau des noch bei der Transferinduktivität L vorhandenen Magnetfelds kann sich ein alternativer Strompfad aus dem Aktor 100 über die Transferinduktivität L und die Diode D1 hin bis zu dem in Figur 2b oberen Anschluss des Pufferkondensators C ausbilden, sodass zumindest ein Teil des Entladestroms des piezoelektrischen Aktors 100 dazu verwendet werden kann, elektrische Energie in den Pufferkondensator C zurückzuspeisen. Dieses Arbeitsprinzip ist an sich bekannt und weitere Details hierzu sind bspw. in der eingangs bereits genannten EP 1 139 448 B1 beschrieben.

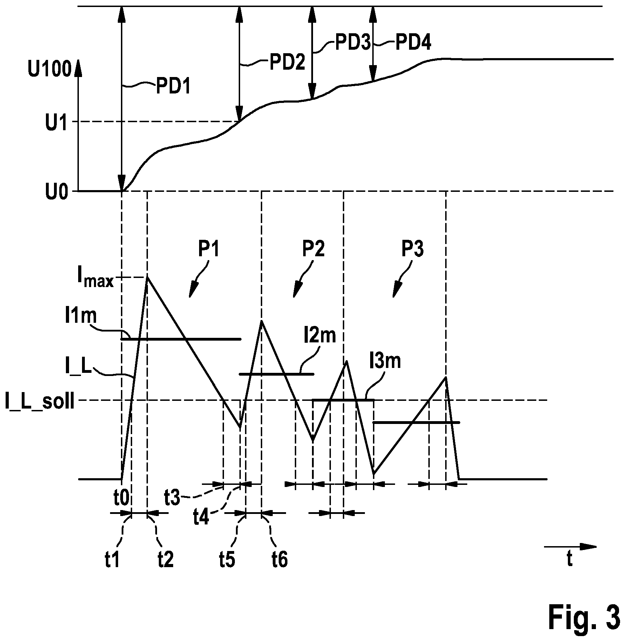

Figur 3 zeigt einen zeitlichen verlauf unterschiedlicher Betriebsgrößen des piezoelektrischen Aktors 100 bzw. der Ansteuereinrichtung 200 während eines Aufladevorgangs.

Es wird davon ausgegangen, dass der Aktor 100 zu einem Zeitpunkt t0 völlig entladen ist, mithin eine Ladespannung U0 = 0 V aufweist. Zu dem Zeitpunkt t0 wird ferner der bereits vorstehend unter Bezugnahme auf Figur 2a beschriebene Betriebszustand der Ansteuereinrichtung 200 für das Aufladen des piezoelektrischen Aktors 100 eingestellt, wodurch sich der in Figur 3 ebenfalls abgebildete Ladestrom I_L einstellt. Ein erster im wesentlichen linearer Anstieg des Ladestroms I_L zwischen den Zeitpunkten t0 und t1 ergibt sich im wesentlichen durch die schaltungstechnischen Gegebenheiten der Ansteuereinrichtung 200, insbesondere das Vorhandensein der Transferinduktivität L in Serie zu dem piezoelektrischen Aktor 100.

Vorliegend soll das Aufladen des Aktors 100 gepulst erfolgen, wobei der Ladestrom I_L vorteilhaft immer dann abgeschaltet werden soll, sobald er einen vorgebbaren ersten Sollwert I_L_soll erreicht hat. Dies ist wie aus Figur 3 ersichtlich erstmals zu dem Zeitpunkt t1 der Fall. Aufgrund von Latenzzeiten bei der Signalerfassung und Verarbeitung bzgl. der Messung des tatsächlichen Ladestroms I_L und auch der sich daran anschließenden Ansteuerung bspw. der Schalter S1, S2 ergibt sich bis zu dem tatsächlichen Öffnen des ersten Schalters S1 zur Unterbrechung des Ladestrompfads gemäß Figur 2a jedoch eine zeitliche Verzögerung bis hin zu dem Zeitpunkt t2. Die Zeitdifferenz t2-t1 ist im Wesentlichen durch Latenzzeiten der Ansteuereinrichtung 200 bedingt. Aus dem zeitlichen Verlauf I_L gemäß Figur 3 erkennt man, dass während der Latenzzeit (t1, t2) der Ladestrom I_L im Wesentlichen linear weiter angestiegen ist auf einen unerwünscht hohen Maximalwert Imax. Erst zu dem Zeitpunkt t2, zu dem der Ladestrompfad durch Öffnen des Schalters S1 tatsächlich unterbrochen wird, nimmt der Ladestrom I_L - wiederum im Wesentlichen linear- zeitlich ab, sodass sich bis etwa zu dem Zeitpunkt t4 ein gemittelter Ladestrom I1m ergibt, wie er in dem Zeitbereich von t0 bis t4 durch den entsprechend bezeichneten horizontalen Strich in Figur 3 symbolisiert ist.

Daraus ist zu erkennen, dass der mittlere Ladestrom I1m den vorgebbaren ersten Sollwert I_L_soll für den Ladestrom I_L wesentlich übersteigt, wodurch Ungenauigkeiten bei der elektrischen Aufladung des piezoelektrischen Aktors 100 entstehen.

Sobald der tatsächliche Ladestrom I_L, der bspw. durch die Steuereinrichtung 230 in der bereits vorstehend beschriebenen Weise messtechnisch erfasst bzw. ermittelt wird, wieder unter den ersten Sollwert I_L_soll fällt, was vorliegend zu dem Zeitpunk t3 erfolgt, wird der Schalter S1 erneut geschlossen, um einen zweiten Ladestrompuls durch den entsprechenden Ladestrompfad zu ermöglichen. Aufgrund weiterer Latenzzeiten erfolgt das tatsächliche Schließen des ersten Schalters S1 allerdings jedoch erst zu dem Zeitpunkt t4 und nicht bereits zu dem Zeitpunkt t3, zu dem tatsächlich der Ladestrom I_L den vorgebbaren ersten Sollwert unterschritten hat.

Das bedeutet, erst zu dem Zeitpunkt t4 wird der erste Schalter S1 (Figur 2a) erneut geschlossen, sodass der Ladestrom I_L wiederum im Wesentlichen linear ansteigt. Zu dem nachfolgenden Zeitpunkt t5 überschreitet der Ladestrom I_L mithin erneut den ersten Sollwert I_L_soll, woraufhin die Steuereinrichtung 230 abermals eine Unterbrechung des Ladestrompfads mittels Öffnen des ersten Schalters S1 bewirken wird. Aufgrund weiterer Latenzzeiten erfolgt dies jedoch erst zu dem nachfolgenden Zeitpunkt t6. Die Latenzzeit zwischen den Zeitpunkten t5, t6 entspricht der bereits beschriebenen Latenzzeit t1, t2 und repräsentiert die aggregierten Latenzzeiten einzelner Komponenten 230, S1 der Ansteuereinrichtung 200 für den Öffnungsvorgang des Schalters S1 und die dazugehörige Erkennung des Überschreitens des vorgebbaren ersten Sollwerts für den Ladestrom I_L.

Zu dem Zeitpunkt t6 wir der erste Schalter S1 (Figur 2a) erneut geöffnet, wodurch der Ladestrom I_L erneut abnimmt und sich das Ansteuermuster wiederholt.

Auf die vorstehend beschriebene Weise kann vorteilhaft ein Aufladevorgang des elektrischen Aktors 100 mittels Strompulsen P1, P2, P3, ... bewirkt werden.

Aufgrund der systemimmanenten Latenzzeiten (Intervalle (t1, t2), (t3, t4), (t5, t6)) ist jedoch der sich tatsächlich ergebende mittlere Ladestrom I1m, I2m, I3m für die entsprechenden Strompulse P1, P2, P3 üblicherweise verschieden von dem ersten Sollwert I_L_soll für den Ladestrom I_L, wodurch sich wie bereits beschrieben Ungenauigkeiten bei der Ansteuerung des piezoelektrischen Aktors 100 während des Aufladens ergeben. Diese Ungenauigkeiten beeinträchtigen die Präzision bei der Kraftstoffzumessung durch ein Einspritzventil (nicht gezeigt), das mittels des Aktors 100 betätigt wird.

Figur 3 zeigt zusätzlich zu dem zeitlichen Verlauf des Ladestroms I_L die Spannung U100 an dem piezoelektrischen Aktor 100 (Fig. 2a).

Erfindungsgemäß ist erkannt worden, dass eine Potentialdifferenz zwischen dem ersten Anschluss 102 des Aktors 100 und einem Bezugspotential (z.B. PB1, PB2), an das der Knotenpunkt K (Figur 1) der Schaltungsanordnung 220 gelegt wird, einen wesentlichen Einfluss auf den Aufladevorgang bzw. den Entladevorgang des Aktors 100 hat.

Insbesondere hängt die Steilheit des zeitlichen Verlaufs des Aufladestroms I_L (Figur 3) von dieser Potentialdifferenz zwischen den Punkten K und 102 ab. Dasselbe gilt für den Entladestrom I_E.

Daher wird erfindungsgemäß vorgeschlagen, diese Potentialdifferenz bei der elektrischen Ansteuerung des Aktors 100 zu berücksichtigen, insbesondere für das Aufladen und/oder für das Entladen.

Figur 3 zeigt in dem Diagramm, in dem die Ladespannung U100 des Aktors 100 aufgetragen ist, die erfindungsgemäß betrachtete Potentialdifferenz zu unterschiedlichen Betriebszeitpunkten während des vorstehend unter Bezugnahme auf Figur 3 beschriebenen Aufladevorgangs.

Eine erste Potentialdifferenz PD1 zwischen dem Punkt 102 (Figur 1) und dem Knotenpunkt K ist zu Beginn (t = t0) des Aufladevorgangs gegeben. Dementsprechend stellt sich zwischen den Zeitpunkten t0, t2 ein Aufladevorgang mit einem entsprechend steilen zeitlichen Anstieg des Ladestroms I_L ein.

Bei dem erneuten Schließen des ersten Schalters S1 zu dem Zeitpunkt t4 ist der Aktor 100 bereits auf eine erste Spannung U1 > U0 aufgeladen, sodass die über der Transferinduktivität L wirksame Potentialdifferenz PD2 zu dem Zeitpunkt t4 entsprechend geringer ist als die erste Potentialdifferenz PD1 zu dem Zeitpunkt t0.

Das gleiche gilt für die weiteren Potentialdifferenzen PD3, PD4.

Entsprechend den vorstehend erläuterten Potentialdifferenzen PD1, .., PD4 stellt sich in den entsprechenden Ladezeitbereichen ab t0 bzw. ab t4 usw. ein Ladestrom I_L mit einem entsprechenden zeitlichen Gradienten ein.

Erfindungsgemäß ist vorgeschlagen, die Potentialdifferenz PD1, PD2, .. bzw. generell die Potentialdifferenz zwischen dem ersten Anschluss 102 des piezoelektrischen Aktors 100 und dem Knotenpunkt K bzw. einem Bezugspotential PB1, PB2, an das der Knotenpunkt K gelegt wird, für die Zwecke des Aufladens bzw. Entladens zu berücksichtigen, insbesondere um die Ansteuerung des piezoelektrischen Aktors 100 in Abhängigkeit von der Potentialdifferenz zu modifizieren, zum Beispiel im Sinne einer genaueren Einstellung des mittleren Ladestroms I1m, I2m, I3m für unterschiedliche Strompulse P1, P2, P3.

Weiter vorteilhaft können - sofern bekannt bzw. ermittelbar bzw. determiniert - alternativ oder ergänzend zu der Betrachtung der Potentialdifferenz über der Transferinduktivität L ein oder mehrere Latenzzeiten der Ansteuereinrichtung 200, wie sie bei der Ermittlung z.B. des Ladestroms I_L sowie der Ansteuerung der Schalter S1, S2 auftreten, berücksichtigt werden für die Ansteuerung des Aktors 100, wodurch eine noch präzisere Ansteuerung des Aktors 100 ermöglicht wird.

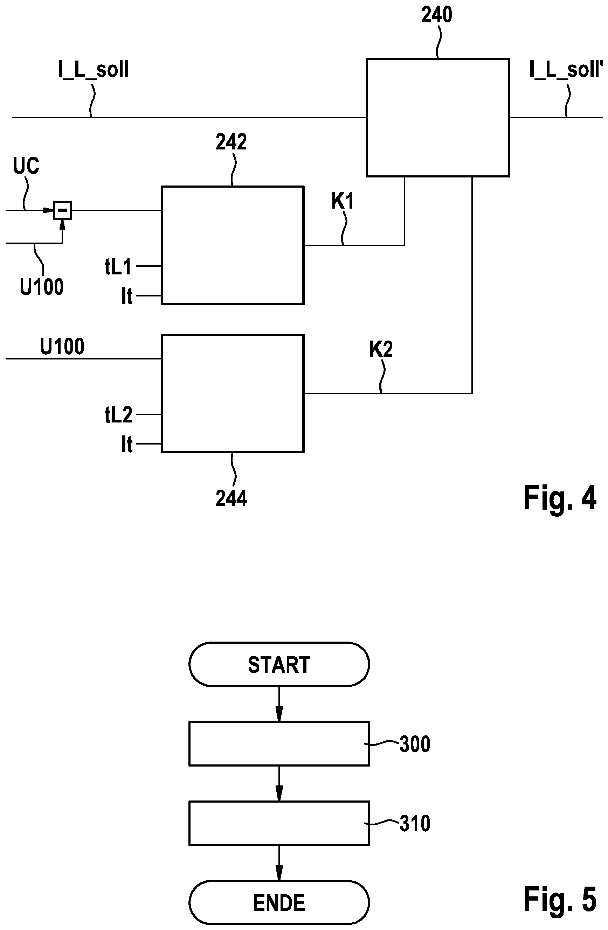

Figur 4 zeigt beispielhaft ein vereinfachtes Blockdiagramm einer Ausführungsform der Erfindung, bei der der Sollwert I_L_soll für den Ladestrom I_L mittels einer Korrektureinrichtung 240 korrigiert wird, um einen korrigierten Sollwert I_L_soll' zu erhalten, mit dem der Aktor 100 anstelle des Sollwerts I_L_soll angesteuert wird, um die vorstehend beschriebenen unerwünschten Effekte (Überschwinger und Unterschwinger des Ladestroms I_L bezüglich des Sollwerts I_L_soll) zu kompensierten.

Der Funktionsblock 240 repräsentiert hierbei die erfindungsgemäße Berücksichtigung der Potentialdifferenz über der Transferinduktivität L, also zwischen dem Anschluss 102 (Figur 1) und dem Schaltungsknoten K, sowie verschiedener Latenzzeiten der Ansteuereinrichtung 200.

Dem Funktionsblock 240 ist eine erste Berechnungseinheit 242 zugeordnet, deren Aufgabe es ist, in Abhängigkeit der Potentialdifferenz zwischen den Punkten 102, K und ggf. auch in Abhängigkeit von bekannten Latenzzeiten der Vorrichtung 200, eine erste Korrektorgröße K1 zu ermitteln und dem Funktionsblock 240 zur Korrektur des Ladestroms bzw. des Sollwerts I_L_soll für den Ladestrom zuzuführen.

Der Berechnungseinheit 242 ist ein Subtrahierer zugeordnet, der eine Differenz aus der an dem Pufferkondensator C (Figur 1) anliegenden Spannung UC und der Aktorspannung U100 bildet und diese Differenz der ersten Berechnungseinheit 242 zuführt. Ferner wird der ersten Berechnungseinheit 242 eine eine erste Latenzzeit charakterisierende Größe tL1 zugeführt, welche die bspw. in einem Testaufbau messtechnisch ermittelten Latenzzeiten in dem Zeitraum t = t1 bis t = t2 (Figur 3) repräsentiert.

Darüber hinaus kann der ersten Berechnungseinheit 242 auch noch eine weitere Eingangsgröße It zugeführt werden, welche einen tatsächlichen Induktivitätswert der Transferinduktivität L (Fig. 1) repräsentiert. Die Kenngröße It kann bspw. in einer besonderen Mess-Betriebsart der Ansteuereinrichtung 200 ermittelt werden oder auch durch ein geeignetes Rechenmodel bereitgestellt werden oder bei der Programmierung bzw. Implementierung der Steuereinrichtung 230 angegeben werden.

In Abhängigkeit der Eingangsgrößen UC, U100, tL1, It ermittelt die erste Berechnungseinheit 242 wie bereits beschrieben eine erste Korrekturgröße K1, welche in dem Funktionsblock 240 zur Modifikation der Sollwerts I_L_soll verwendet werden kann. Bspw. kann die erste Korrekturgröße K1 eine Verringerung des Sollwerts I_L_soll für den Ladestrom I_L vorsehen, wenn der ersten Berechnungseinheit 242 eingangsseitig ein verhältnismäßig großer Wert für die Latenzzeit tL1 zugeführt wird, um der Tatsache Rechnung zu tragen, dass aufgrund der Latenzzeit tL1 z.B. nach dem Zeitpunkt t1 (Fig.3 ) ein Stromüberschwinger stattfinden wird und der erfindungsgemäß betrachtete Schwellwert dementsprechend verringert werden kann, um ein allzu starkes Überschwingen des Ladestroms über den Sollwert I_L_soll hinaus zu vermeiden.

In ähnlicher Weise wird die Differenz zwischen der Aktorspannung U100 und der Kondensatorspannung UC, die das erste Bezugspotential PB1 präsentiert, in der ersten Berechnungseinheit 242 berücksichtigt. Beispielsweise kann bei einer verhältnismäßig großen Differenz UC - U100 auf einen entsprechend steilen zeitlichen Stromanstieg während des Aufladens geschlossen werden, und es kann wiederum der Sollwert I_L_soll mittels einer entsprechend ausgewählten ersten Korrekturgröße K1 an die verhältnismäßig große Potentialdifferenz zwischen den Knotenpunkten 102, K angepasst werden, um eine präzisere Ansteuerung des Aktors 100 während des Aufladens zu ermöglichen.

Analog zu der ersten Berechnungseinheit 242 ist ferner eine zweite Berechnungseinheit 244 vorgesehen, welche eine zweite Korrekturgröße K2 ermittelt und dem Funktionsblock 240 zur weiteren Korrektur des Sollwerts I_L_soll bereitstellt. Die zweite Berechnungseinheit 244 erhält eingangsseitig die Aktorspannung U100. Nach dem Öffnen des ersten Schalters S1 im Rahmen eines Ladevorgangs des Aktors 100 ist die für den weiteren zeitlichen Verlauf des Ladestroms I_L maßgebliche Potentialdifferenz nämlich nährungsweise durch die Potentialdifferenz zwischen dem ersten Anschluss 102 des Aktors 100 und dem gemeinsamen Massepotential PB2 gegeben. Sofern - wie vorliegend - der zweite Anschluss 104 des Aktors 100 mit dem gemeinsamen Massepotential PB2 verbunden ist, wirkt demnach als Potentialdifferenz über der Transferinduktivität L die Aktorspannung U100, sobald der erste Schalter S1 während eines Strompulses P1, P2, P3 geöffnet wird. Das bedeutet, sobald während eines Ladevorgangs des Aktors 100 der erste Schalter S1 (Figur 1) ausgehend von einem geschlossenen Vorstand wieder geöffnet wird, ergibt sich ein zeitlicher Stromgradient des Ladestroms I_L, der proportional ist zu der Aktorspannung U100. Diese Größe wird durch die zweite Berechnungseinheit 244 dem erfindungsgemäßen Prinzip folgend vorteilhaft berücksichtigt, um auch in den fallenden Flanken des Ladestroms I_L während der Pulse P1, P2, P3 (Figur 3) eine präzisere Ansteuerung des Aktors 100 zu ermöglichen, z.B. um zu große Stromunterschwinger unter den Sollwert I_soll zu vermeiden. Sofern bspw. die Aktorspannung U100 verhältnismäßig große Werte aufweist, ist von einem entsprechend steilen absinken des Ladestroms I_L z.B. in dem Zeitbereich von t = t2 bis t = t4 auszugehen. Dementsprechend kann der vorgebbare Sollwert I_L_soll vermöge der durch die zweite Berechnungseinheit 244 gelieferten zweiten Korrekturgröße K2 dahingehend korrigiert werden, dass der Unterschwinger des Ladestroms in dem Latenzzeitbereich t = t3 bis t = t4 verringert wird, und somit eine weitere Annäherung an den tatsächlich gewünschten Ladestrom, nämlich den Soll-Ladestrom I_L_soll, bewerkstelligt wird.

Analog zu der ersten Berechnungseinheit 242 kann auch die zweite Berechnungseinheit 244 vorteilhaft entsprechende Latenzzeiten tL2 sowie die tatsächlich wirksame Induktivität It der Transferinduktivität L berücksichtigen.

Die erste Berechnungseinheit 242 ist den vorstehenden Ausführungen entsprechend für eine Kompensation von Stromüberschwingern über den Sollwert I_L_soll nutzbar, und die zweite Berechnungseinheit 244 ist für eine Kompensation von Stromunterschwingern unter den Sollwert I_L_soll nutzbar.

Die Größe tL2 repräsentiert hierbei bevorzugt ein Maß für die an sich unerwünschte Latenzzeit in dem Zeitbereich t3, t4 gemäß Figur 3.

Der Funktionsblock 240 modifiziert den vorgebbaren Sollwert I_L_soll für den Ladestrom in Abhängigkeit der Korrekturgrößen K1, K2, beispielsweise auf der Basis eines Kennfelds oder auch additiv bzw. multiplikativ, wodurch der korrigierte Sollwert I_L_soll' für den Ladestrom I_L erhalten wird. Mit diesem korrigierten Sollwert I_L_soll' wird der Aktor 100 bevorzugt für mindestens einen nachfolgenden Strompuls P2 betrieben, um die vorstehend mehrfach beschriebenen unerwünschten Effekte von Stromüberschwingern bzw. Unterschwingern zu kompensieren.

Die Funktionalität der in Fig. 4 abgebildeten Funktionsblöcke 240, 242, 244 kann z.B. in einer Recheneinheit der Steuereinrichtung 230 (Fig. 1), beispielsweise einem Mikrocontroller, integriert sein.

Figur 5 zeigt ein vereinfachtes Flussdiagramm einer Ausführungsform des erfindungsgemäßen Verfahrens. In einem ersten Schritt 300 wird die Potentialdifferenz zwischen dem ersten Anschluss 102 des Aktors 100 und dem ersten Bezugspotential PB1, welches bspw. für das Aufladen des Aktors 100 verwendet werden soll und bei geschlossenem ersten Schalter S1 an der Transferinduktivität L anliegt, ermittelt. Die Ermittlung 300 der Potentialdifferenz erfolgt bspw. durch eine Messung der Kondensatorspannung UC und der Aktorspannung U100 und durch entsprechende Differenzbildung gemäß der Maschenregel, sofern beide Komponenten C, 100 ein gemeinsames zweites Bezugspotential PB2, wie vorliegend das Massepotential, aufweisen.

Das erfindungsgemäße Prinzip ist vorteilhaft auch auf Schaltungskonfigurationen anwendbar, bei denen kein gemeinsames Massepotential PB2 für die Komponenten C, 100 gegeben ist. In diesem Fall muss die erfindungsgemäß betrachtete Potentialdifferenz über der Transferinduktivität in geeigneter Weise berechnet werden.
In einem zweiten Schritt 310 des erfindungsgemäßen Verfahrens wird die ermittelte Potentialdifferenz vorteilhaft für die weitere Ansteuerung des Aktors 100 berücksichtigt. Bei einer bevorzugten Ausführungsform kann dies bspw. in Form des Funktionsdiagramms der Figur 4 erfolgen. Besonders vorteilhaft wird die Potentialdifferenz über der Transferinduktivität L, welche während des Aufladens bzw. des Entladens u.a. den Stromgradienten bestimmt, wiederholt ermittelt, besonders bevorzugt periodisch und/oder jeweils von einer geplanten Ansteuerung des Aktors 100.

Besonders bevorzugt erfolgt die Ermittlung der Potentialdifferenz bspw. zu den Zeitpunkten t0, t2, t4, t6, also insbesondere zu denjenigen Zeitpunkten, zu denen bspw. der erste Schalter S1 tatsächlich einen Betriebszustandswechsel (Öffnen, Schließen) erfährt. Dadurch ist vorteilhaft sichergestellt, dass stets die aktuelle Potentialdifferenz, die an der Transferinduktivität L wirkt, vorliegt, wodurch eine weitere Steigerung der Präzision bei der Kompensation der Ansteuerung des Aktors 100 für nachfolgende Strompulse gegeben ist.

Das erfindungsgemäße Prinzip, das unter Bezugnahme auf Fig. 3 und 4 anhand eines Aufladevorgangs des Aktors 100 beschrieben worden ist, ist ohne weiteres übertragbar auf einen Entladevorgang des Aktors 100. Bspw. kann analog zu dem gepulsten Aufladen gemäß Figur 3 auch ein gepulstes Entladen erfolgen, was durch zyklisches Öffnen bzw. Schließen des Entladeschalters S2 (Figur 2b) bei gleichzeitig geöffnetem ersten Schalter S1 bewerkstelligt wird. Bei der in Figur 2b abgebildeten Schaltungstopologie der Ansteuereinrichtung 200 entspricht die an der Transferinduktivität L abfallende Spannung - bei geschlossenem zweiten Schalter S2 - der Aktorspannung U100. Das bedeutet, die Aktorspannung U100 ist direkt maßgeblich für den Stromgradienten des Entladestroms I_E, sodass unter Kenntnis der Aktorspannung U100 vorteilhaft eine Kompensation eines zweiten Sollwerts für den Entladestrom I_E -analog zu den vorstehenden Ausführungsformen, die anhand des Ladestroms beschrieben worden sind - erzielbar ist, solange der zweite Schalter S2 geschlossen ist.

Wenn der zweite Schalter S2 während des Entladens geöffnet wird, z.B. weil der Entladestrom I_E den zweiten Sollwert übersteigt, wirkt an der Transferinduktivität L die Potentialdifferenz U100 - UC; diese beeinflusst während der fallenden Flanke des Entladestroms I_E den zeitlichen Stromgradienten und kann ebenso für die Ansteuerung während des Entladens des Aktors 100 berücksichtigt werden.

Ferner können die Latenzzeiten und der Induktivitätswert It ebenfalls berücksichtigt werden, um eine Ansteuerung des Aktors 100 für den Entladevorgang zu modifizieren.

Bei einer besonders bevorzugten Ausführungsform kann allein die Potentialdifferenz an der Transferinduktivität L berücksichtigt werden, um die Ansteuerung des Aktors 100 zu beeinflussen, bspw. die entsprechenden Sollwerte für den Ladestrom bzw. Entladestrom zu modifizieren. Eine noch präzisere Ansteuerung des Aktors 100 ergibt sich vorteilhaft jedoch durch die weitere Berücksichtigung der Latenzzeiten (tL1, tL2, Figur 4) sowie ggf. durch die zusätzliche Berücksichtigung der tatsächlichen Induktivität It der Längsinduktivität L.

Das erfindungsgemäße Prinzip ist vorteilhaft auch dann anwendbar, wenn der Aktor 100 ohne eine Mehrzahl von Strom pulsen Auf- bzw. Entladen werden soll. Bspw. kann die erfindungsgemäße Berücksichtigung der Potentialdifferenz und/oder der Latenzzeiten bzw. der tatsächlichen Induktivität auch dann von Vorteil sein, wenn das Aufladen, bzw. das Entladen innerhalb eines einzigen, ununterbrochenen Bestromens mit einem Ladestrom bzw. einem Entladestrom erfolgt.

Bei dem Einsatz des erfindungsgemäß betriebenen Aktors 100 in einem Kraftstoffeinspritzventil für eine Brennkraftmaschine lassen sich besonders vorteilhaft auch sehr kleine Einspritzmengen mit großer Präzision realisieren, da die erfindungsgemäße Kompensation von Stromüber- und Unterschwingern direkt eine Verringerung entsprechender Stellfehler des Aktors 100 zur Folge hat.

## Patentansprüche

1. Verfahren zum Aufladen oder Entladen eines piezoelektrischen Aktors (100), wobei ein erster Anschluss (102) des Aktors (100) zumindest zeitweise über eine Transferinduktivität (L) an ein erstes Bezugspotential (PB1) gelegt wird, **dadurch gekennzeichnet, dass** eine Ansteuerung des Aktors (100) in Abhängigkeit einer Potentialdifferenz zwischen dem ersten Bezugspotential (PB1) und einem Potential (P102) an dem ersten Anschluss (102) des Aktors (100) ausgeführt wird, und die Potentialdifferenz wiederholt, jeweils vor einer geplanten Ansteuerung des Aktors (100), ermittelt wird.

2. Verfahren nach einem der vorstehenden Ansprüche, wobei der Aktor (100) unter Verwendung von Strompulsen aufgeladen und/oder entladen wird.

3. Verfahren nach einem der vorstehenden Ansprüche, wobei für das Aufladen der erste Anschluss (102) des Aktors (100) mindestens einmal, vorzugsweise jedoch mehrmals, solange an das erste Bezugspotential (PB1) gelegt wird, bis ein über die Transferinduktivität (L) in den Aktor (100) fließender Aufladestrom (I_L) einen vorgebbaren ersten Sollwert (I_L_soll) überschreitet.

4. Verfahren nach einem der vorstehenden Ansprüche, wobei für das Entladen der erste Anschluss (102) des Aktors (100) mindestens einmal, vorzugsweise jedoch mehrmals, solange an ein zweites Bezugspotential (PB2) gelegt wird, bis ein über die Transferinduktivität (L) aus dem Aktor (100) fließender Entladestrom (I_E) einen vorgebbaren zweiten Sollwert überschreitet.

5. Verfahren nach einem der vorstehenden Ansprüche, wobei ein kapazitives Element (C) verwendet wird, um das erste Bezugspotential (PB1) bereitzustellen, und wobei eine Spannung (UC), die an dem kapazitiven Element (C) anliegt, ermittelt wird, wobei vorzugsweise auch eine an dem Aktor (100) anliegende Spannung (U102) ermittelt wird.

6. Verfahren nach einem der vorstehenden Ansprüche, wobei mindestens eine einen zeitlichen Verlauf des während des Aufladens durch den Aktor (100) fließenden Stroms (I_L) beeinflussende Größe und/oder mindestens eine einen zeitlichen Verlauf des während des Entladens durch den Aktor (100) fließenden Stroms (I_E) beeinflussende Größe in Abhängigkeit der Potentialdifferenz zwischen dem ersten Bezugspotential (PB1) bzw. dem zweiten Bezugspotential (PB2) und dem Potential (P102) an dem ersten Anschluss (102) des Aktors (100) gewählt wird.

7. Verfahren nach einem der Ansprüche 3 bis 6, wobei der erste Sollwert (I_L_soll) und/oder der zweite Sollwert in Abhängigkeit der Potentialdifferenz gewählt wird, vorzugsweise zusätzlich in Abhängigkeit von a) mindestens einer Latenzzeit einer den Aktor (100) ansteuernden Ansteuereinrichtung (200) und/oder b) einer Induktivität der Transferinduktivität (L).

8. Ansteuereinrichtung (200) zum Aufladen oder Entladen eines piezoelektrischen Aktors (100), wobei die Ansteuereinrichtung (200) dazu ausgebildet ist, einen ersten Anschluss (102) des Aktors (100) zumindest zeitweise über eine Transferinduktivität (L) an ein erstes Bezugspotential (PB1) zu legen, **dadurch gekennzeichnet, dass** die Ansteuereinrichtung (200) dazu ausgebildet ist, eine Ansteuerung des Aktors (100) in Abhängigkeit einer Potentialdifferenz zwischen dem ersten Bezugspotential (PB1) und einem Potential (P102) an dem ersten Anschluss (102) des Aktors (100) auszuführen, wobei die Ansteuereinrichtung (200) dazu ausgebildet ist, die Potentialdifferenz wiederholt, jeweils vor einer geplanten Ansteuerung des Aktors (100), zu ermitteln.

## Claims

1. Method for charging or discharging a piezo-electric actuator (100), wherein a first terminal (102) of the actuator (100) is connected at least partially via a transfer inductor (L) to a first reference potential (PB1), **characterized in that** the actuator (100) is actuated as a function of a potential difference between the first reference potential (PB1) and a potential (P102) at the first terminal (102) of the actuator (100), and the potential difference is repeatedly determined, in each case before a planned actuation of the actuator (100).

2. Method according to one of the preceding claims, wherein the actuator (100) is charged and/or discharged using current pulses.

3. Method according to one of the preceding claims, wherein for charging, the first terminal (102) of the actuator (100) is connected to the first reference potential (PB1) at least once but preferably multiple times until a charge current (I_L) flowing into the actuator (100) via the transfer inductor (L) exceeds a predefinable first setpoint value (I_L_setp).

4. Method according to one of the preceding claims, wherein for discharging, the first terminal (102) of the actuator (100) is connected at least once, but preferably multiple times, to a second reference potential (PB2) until a discharge current (I_E) flowing out of the actuator (100) via the transfer inductor (L) exceeds a predefinable second setpoint value.

5. Method according to one of the preceding claims, wherein a capacitive element (C) is used in order to make available the first reference potential (PB1), and wherein a voltage (UC) which is present at the capacitive element (C) is determined, wherein preferably a voltage (U102) which is present at the actuator (100) is also determined.

6. Method according to one of the preceding claims, wherein at least one variable which influences a time profile of the current (I_L) flowing through the actuator (100) during the charging and/or at least one variable which influences a time profile of the current (I_E) flowing through the actuator (100) during the discharging are/is selected as a function of the potential difference between the first reference potential (PB1) and/or the second reference potential (PB2) and the potential (P102) at the first terminal (102) of the actuator (100).

7. Method according to one of Claims 3 to 6, wherein the first setpoint value (I_L_setp) and/or the second setpoint value are/is selected as a function of the potential difference, preferably additionally as a function of a) at least one latency time of an actuation device (200) which actuates the actuator (100) and/or b) of an inductance of the transfer inductor (L).

8. Actuation device (200) for charging or discharging a piezo-electric actuator (100), wherein the actuation device (200) is designed to connect a first terminal (102) of the actuator (100) at least temporarily via a transfer inductor (L) to a first reference potential (PB1), **characterized in that** the actuation device (200) is designed to actuate the actuator (100) as a function of a potential difference between the first reference potential (PB1) and a potential (P102) at the first terminal (102) of the actuator (100), wherein the actuation device (200) is designed to determine the potential difference repeatedly, in each case before a planned actuation of the actuator (100).

## Revendications

1. Procédé pour charger ou décharger un actionneur piézoélectrique (100), dans lequel un premier raccord (102) de l'actionneur (100) reçoit au moins temporairement un premier potentiel de référence (PB1) via une inductance de transfert (L), **caractérisé en ce qu'**une commande de l'actionneur (100) est réalisée en fonction d'une différence de potentiel entre le premier potentiel de référence (PB1) et un potentiel (P102) au niveau du premier raccord (102) de l'actionneur (100), et **en ce que** la différence de potentiel est déterminée de manière répétée, respectivement avant une commande planifiée de l'actionneur (100).

2. Procédé selon la revendication précédente, dans lequel l'actionneur (100) est chargé et/ou déchargé par utilisation d'impulsions de courant.

3. Procédé selon l'une quelconque des revendications précédentes, dans lequel, pour la charge, le premier raccord (102) de l'actionneur (100) reçoit le premier potentiel de référence (PB1) au moins une fois, mais de préférence plusieurs fois tant qu'un courant de charge (I_L) passant dans l'actionneur (100) via l'inductance de transfert (L) dépasse une première valeur théorique (I_L_soll) pouvant être prédéterminée.

4. Procédé selon l'une quelconque des revendications précédentes, dans lequel, pour la décharge, le premier raccord (102) de l'actionneur (100) reçoit un second potentiel de référence (PB2) au moins une fois, mais de préférence plusieurs fois tant qu'un courant de décharge (I_E) sortant de l'actionneur (100) via l'inductance de transfert (L) dépasse une seconde valeur théorique pouvant être prédéterminée.

5. Procédé selon l'une quelconque des revendications précédentes, dans lequel un élément capacitif (C) est utilisé pour fournir le premier potentiel de référence (PB1) et dans lequel une tension (UC) appliquée à l'élément capacitif (C) est déterminée, dans lequel une tension (U102) appliquée à l'actionneur (100) est de préférence également déterminée.

6. Procédé selon l'une quelconque des revendications précédentes, dans lequel au moins une grandeur ayant une influence sur une évolution temporelle du courant (I_L) passant à travers l'actionneur (100) pendant la charge et/ou au moins une grandeur ayant une influence sur une évolution temporelle du courant (I_E) passant à travers l'actionneur (100) pendant la décharge est/sont sélectionnée(s) en fonction de la différence de potentiel entre le premier potentiel de référence (PB1) ou le second potentiel de référence (PB2) et le potentiel (P102) au niveau du premier raccord (102) de l'actionneur (100).

7. Procédé selon l'une quelconque des revendications 3 à 6, dans lequel la première valeur théorique (I_L_soll) et/ou la seconde valeur théorique est/sont sélectionnée(s) en fonction de la différence de potentiel, et de préférence, en outre, en fonction a) d'au moins un temps de latence d'un dispositif de commande (200) commandant l'actionneur (100) et/ou b) d'une valeur de l'inductance de transfert (L).

8. Dispositif de commande (200) destiné à charger ou décharger un actionneur piézoélectrique (100), dans lequel le dispositif de commande (200) est conçu pour appliquer à un premier raccord (102) de l'actionneur (100) au moins temporairement un premier potentiel de référence (PB1) via une inductance de transfert (L), **caractérisé en ce que** le dispositif de commande (200) est conçu pour effectuer une commande de l'actionneur (100) en fonction d'une différence de potentiel entre le premier potentiel de référence (PB1) et un potentiel (P102) au niveau du premier raccord (102) de l'actionneur (100), dans lequel le dispositif de commande (200) est conçu pour déterminer la différence de potentiel de manière répétée, respectivement avant une commande planifiée de l'actionneur (100).
